(19) **Europäisches Patentamt European Patent Office Office européen des brevets**

(11) **EP 3 476 036 B1**

(12) **FASCICULE DE BREVET EUROPEEN**

(45) Date de publication et mention de la délivrance du brevet:
**27.10.2021 Bulletin 2021/43**

(51) Int Cl.:
*H02M 7/5387* (2007.01)   *H02M 1/34* (2007.01)
*H02M 7/00* (2006.01)

(21) Numéro de dépôt: **17730184.3**

(22) Date de dépôt: **16.06.2017**

(86) Numéro de dépôt international:
**PCT/EP2017/064811**

(87) Numéro de publication internationale:
**WO 2017/220448 (28.12.2017 Gazette 2017/52)**

(54) **SYSTÈME ET PROCÉDÉ DE CONVERSION D'UNE PUISSANCE ÉLECTRIQUE CONTINUE EN PUISSANCE ÉLECTRIQUE ALTERNATIVE TRIPHASEE AVEC RADIATEUR A AIR**

SYSTEM UND VERFAHREN ZUR UMWANDLUNG VON GLEICHSTROM IN DREIPHASIGEN WECHSELSTROM MIT EINEM LUFTRADIATOR

SYSTEM AND METHOD FOR CONVERTING DC POWER INTO THREE-PHASE AC POWER, THE SYSTEM COMPRISING AN AIR RADIATOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **22.06.2016  FR 1655812**

(43) Date de publication de la demande:
**01.05.2019  Bulletin 2019/18**

(73) Titulaire: **Mavel EDT S.p.A.**
**11026 Pont-Saint-Martin (AO) (IT)**

(72) Inventeurs:
• **FRANCESSETTI, Marco**
  **10071 Borgaro Torinese (IT)**
• **BETTONI, Davide**
  **Settimo Vittone To Italy (IT)**
• **DIB, Wissam**
  **92150 Seresnes (FR)**

(74) Mandataire: **Leoncini, Alberto et al**
**A.Bre.Mar. s.r.l.**
**Consulenza in Proprietà Industriale**
**Via Servais, 27**
**10146 Torino (IT)**

(56) Documents cités:
**DE-A1- 10 020 137    US-A- 4 566 051**
**US-A- 5 184 291    US-A1- 2005 270 745**

• **Wikipedia: "Power module - Wikipedia", , 7 March 2016 (2016-03-07), XP055745042, Retrieved from the Internet: URL:https://en.wikipedia.org/w/index.php?title=Power_module&oldid=708758817 [retrieved on 2020-10-29]**
• **Anonymous: "Printed circuit board - Wikipedia", , 28 April 2016 (2016-04-28), XP055745061, Retrieved from the Internet: URL:https://en.wikipedia.org/w/index.php?title=Printed_circuit_board&oldid=717596632 [retrieved on 2020-10-29]**
• **Wikipedia: "Thermal management (electronics) - Wikipedia", , 12 April 2016 (2016-04-12), XP055745070, Retrieved from the Internet: URL:https://en.wikipedia.org/w/index.php?title=Thermal_management_(electronics)&oldid=714976510 [retrieved on 2020-10-29]**

**Description**

La présente invention concerne le domaine des convertisseurs pour la conversion de l'énergie électrique, notamment pour les machines électriques à haute vitesse et/ou à vitesse variable.

Un convertisseur statique est un système permettant de convertir un signal électrique en un autre signal électrique possédant des caractéristiques différentes. Par exemple, un convertisseur peut permettre de convertir une tension alternative en une autre tension alternative avec une fréquence et/ou une amplitude différente, on parle alors de convertisseur alternatif/alternatif ou AC/AC. Selon un autre exemple, un convertisseur peut permettre de convertir une tension alternative en une tension continue, on parle alors de convertisseur alternatif/continu ou AC/DC. Pour la conversion inverse continu/alternatif, on parle de convertisseur DC/AC. Selon un dernier exemple, un convertisseur peut convertir une tension continue en une tension continue de tension différente, on parle alors de convertisseur DC/DC. Les convertisseurs peuvent être réversibles ou non réversibles. Généralement, la conversion est mise en œuvre au moyen de commutateurs (interrupteurs) commandés.

Pour piloter des machines électriques, notamment des machines électriques à aimants permanents, à partir de système(s) de stockage d'énergie électrique (par exemple une batterie), il est nécessaire de convertir l'énergie électrique continue en énergie alternative triphasée. Cette conversion peut être réalisée au moyen d'un convertisseur DC/AC. Un tel convertisseur doit fournir trois tensions électriques sinusoïdales déphasées de 120° les unes par rapport aux autres, et dont l'amplitude dépend directement du couple demandé (mais aussi du régime de rotation), et dont la fréquence dépend uniquement du régime de rotation de la machine électrique reliée au convertisseur.

Classiquement, un convertisseur DC/AC comprend trois bras de commutations. Chaque bras de commutation comporte deux commutateurs commandés et deux diodes placées en parallèle aux commutateurs commandés. En fonction du courant de charge demandé, un bras peut être composé de plusieurs 'sous bras' en parallèle. Les phases de la machine électrique sont reliées au point milieu de chaque bras. On commande chaque bras séparément en pilotant l'ouverture et la fermeture des commutateurs sur des périodes de découpage, de manière à former un signal triphasé.

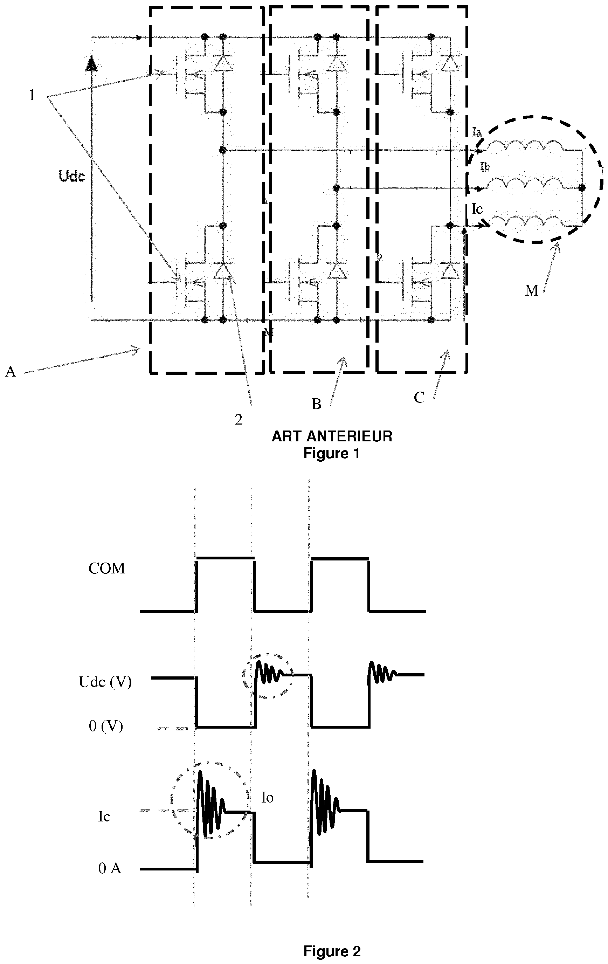

La figure 1 illustre un tel convertisseur classique DC/AC. La tension continue du moyen de stockage d'énergie électrique est indiquée Udc. Le moteur triphasé M est représenté schématiquement par trois bobines, alimentées respectivement par les courants Ia, Ib et Ic. Le convertisseur comporte trois bras de commutation A, B, C, chaque bras de commutation A, B, C est relié à une phase de la machine électrique M. Chaque bras de commutation comporte deux commutateurs 1 et deux diodes 2. Les bras de commutation A, B, C sont disposés en parallèle, entre les deux phases d'entrée continues du convertisseur de tension Udc. Les phases de sortie des bras de commutation A, B, C sont reliées au point milieu (entre les deux commutateurs) des bras de commutation.

La figure 2 représente le signal de commande COM des interrupteurs avec un rapport cyclique constant de 50%, la tension Udc et le courant Ic aux bornes d'un commutateur, pour un convertisseur DC/AC classique (tel que décrit ci-dessus en référence à la figure 1). Pour le signal de commande COM, la partie basse du créneau correspond au commutateur ouvert, et la partie haute du créneau correspond au commutateur fermé. On parle pour ce cas de commutation dite dure ou 'tout ou rien' (de l'anglais « hard switching »). On remarque que pour cette conception du convertisseur, des dépassements de la tension Udc et du courant Io apparaissent. Le courant Io correspond à la valeur permanente de Ic, et correspond au courant envoyé à la machine électrique.

Ainsi, les principaux inconvénients de cette conception classique du convertisseur sont les suivants :

- pertes par commutation : cette conception présente des pertes par commutation importantes, ce qui tend à rendre son utilisation incompatible à des fréquences de commutation élevées, et donc pour des machines électriques utilisées à très hautes vitesses,
- dépassement de courant/tension : comme présenté sur la figure 2, cette stratégie présente des dépassements de tension (de l'anglais « overshoot ») et de courant lors de la commutation instantanée de l'interrupteur. Ainsi, ce type de pilotage nécessite une prise de marge sur la tension et le courant des différents composants lors de la conception du convertisseur (appelé aussi onduleur). Cela implique un surdimensionnement des composants utilisés, (par exemple : pour une tension de bus continu de 300 Volt, on utilise un commutateur IGBT avec une tension nominale de 600 Volt pour prendre en compte ces dépassements de tension et de courant), et
- émissions électromagnétiques importantes (CEM).

En partant des inconvénients de la stratégie « Hard switching » (pertes, incompatibilité avec les moteurs à hautes vitesses), une conception dite commutation douce (ou de l'anglais « Soft switching ») a été développée. Ainsi, pour limiter les dépassements du courant et de la tension sur les commutateurs, une bobine et un condensateur sont ajoutés sur le circuit précédent. La bobine module la variation du courant di/dt (« Turn-On »), et le condensateur module la variation de la tension dv/dt (« Turn-Off »). De plus, et dans le but d'assurer le fonctionnement du circuit, et donc un bilan énergétique nul, une résistance est ajoutée dans le circuit entre la tension de la source d'énergie utilisée et le circuit capacitif. Cette résistance permet d'assurer le fonctionnement de ce circuit et de rebaisser la tension aux bornes du circuit capacitif. Une telle conception de convertisseur DC/AC est décrite notamment dans la demande de brevet WO 11016854.

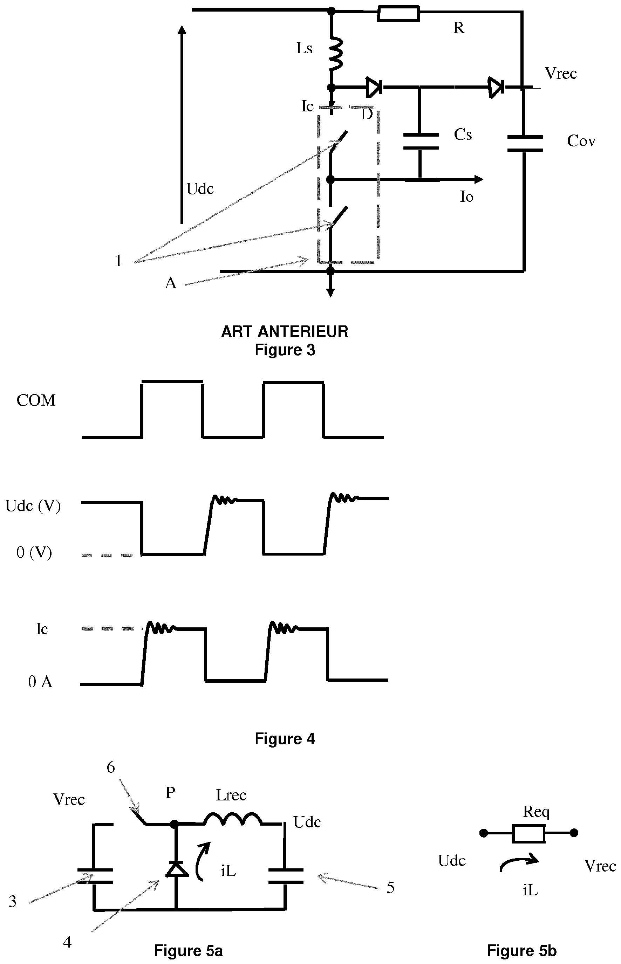

La figure 3 représente un schéma simplifié d'un bras de commutation (avec deux commutateurs 1) avec une capacité Cs, une bobine Ls, une résistance R et une capacité Cov pour une commutation douce. Ce circuit est connu par l'appellation anglaise « Undeland Snubber ». La tension Udc correspond à la tension aux bornes du moyen de stockage de l'énergie électrique continue. La bobine Ls est placée entre une phase d'entrée continue Udc et le bras de commutation A. Une branche part de la jonction entre la bobine Ls et le bras de commutation A, cette branche comporte deux diodes D, et arrive en une jonction entre la résistance R et le condensateur Cov. L'autre extrémité de la résistance R est connectée à la phase d'entrée continue du convertisseur. L'autre extrémité du condensateur Cs est connectée à la phase de sortie alternative du bras de commutation A. L'autre extrémité de la capacité Cov est connectée à la masse. La capacité Cs permet de moduler l'évolution de la tension aux bornes du commutateur. Cette capacité stocke une part de l'énergie due à la commutation douce des interrupteurs. L'autre partie de cette énergie est stockée dans une capacité d'une valeur plus élevée Cov. Ensuite, l'énergie stockée dans la capacité est renvoyée au système de stockage utilisé (batterie) à travers la résistance. La bobine Ls permet de moduler l'évolution du courant aux bornes du commutateur. En fait, l'énergie créée par la bobine Ls n'est pas en entièrement stockée dans la capacité Cs, d'où l'intérêt d'une deuxième capacité Cov d'une valeur plus élevée que Cs. La résistance assure le fonctionnement du système et permet de rebaisser la tension Vrec.

La figure 4 présente, de manière similaire à la figure 2, le signal de commutation COM, l'évolution de la tension Udc et du courant Ic du commutateur lors d'une commutation dite « soft ». Pour le signal de commande COM, la partie basse du créneau correspond au commutateur ouvert, et la partie haute du créneau correspond au commutateur fermé. On remarque sur cette figure, que les dépassements de tension Udc et de courant Ic sont diminués par rapport à la commutation dite « hard ».

Les avantages de la commutation douce sont :

- moins de pertes par commutation, cette conception du convertisseur est compatible avec des fréquences de commutation élevées, ainsi, cette conception peut être utilisée pour piloter des machines électriques à hautes vitesses,
- peu de dépassement de tension et du courant sur le commutateur, donc plus besoin de surdimensionner les composants, et
- l'évolution de la tension et du courant aux bornes des commutateurs lors de la transition est modulée par le choix de Ls et Cs respectivement.

Cette conception du convertisseur nécessite un agencement particulier des différents composants électriques, ce qui rend leur montage long et complexe. Par ailleurs, cette conception du convertisseur présente un inconvénient majeur, qui est la nécessité de dissiper une énergie dans la résistance, dont l'objectif est de rendre le bilan énergétique des éléments passifs nul, et donc de rebaisser la tension Vrec, ce qui implique des pertes énergétiques, et par conséquent une diminution de l'efficacité du convertisseur.

En outre, une autre contrainte de conception du convertisseur est son encombrement qui doit être limité.

De plus, une autre contrainte de la conception des convertisseurs est la température des composants au sein du convertisseur, qui soulève la problématique du refroidissement des composants électroniques. Généralement, le refroidissement réalisé par circulation d'un liquide, par exemple de l'eau, surtout pour une tension d'alimentation Udc élevée (par exemple supérieure à 200V). Un tel refroidissement nécessite un circuit de circulation complexe (pompe, etc.) et encombrant.

Les demandes de brevets DE10020137, US4566051, US5184291 et US2005/270745 décrivent différents convertisseurs.

Pour pallier à ces inconvénients, la présente invention concerne un système de conversion d'une puissance électrique continue en puissance électrique alternative triphasée selon la revendication 1. Le système de conversion comprend trois bras de commutation, un circuit de modulation, et un module récupérateur d'énergie électrique. Ces composants sont montés sur une carte de circuit imprimé, de telle sorte qu'au moins les bras de commutation et la bobine de modulation sont en contact avec un radiateur de refroidissement à air. L'utilisation d'un refroidissement à air permet de refroidir les composants électroniques de manière simple et peu encombrante. De plus, au moyen du circuit de modulation, une commutation douce est mise en œuvre, ce qui diminue notamment les pertes par commutations, et les dépassements de tension et de courant sur les commutateurs. En outre, le module récupérateur d'énergie électrique permet d'optimiser l'efficacité du convertisseur.

## Le système selon l'invention

La présente invention concerne un système de conversion d'une puissance électrique continue en puissance électrique alternative triphasée comprenant trois bras de commutation, un circuit de modulation des variations de tension et d'intensité, et un module récupérateur d'énergie électrique, ledit circuit de modulation comprenant un condensateur de modulation et une bobine de modulation par phase de sortie dudit système de conversion. Lesdits bras de commutation, ledit circuit de modulation et ledit module récupérateur d'énergie sont connectés sur une carte de circuit imprimé de telle sorte qu'au moins lesdits bras de commutation et ladite bobine de modulation sont en contact avec un radiateur de refroidissement à air.

Selon un mode de réalisation de l'invention, ledit radiateur de refroidissement à air comprend une plaque métallique sensiblement plane, et au moins une ailette sur le côté de ladite plaque métallique opposé au côté en contact avec lesdits bras de commutation et ladite bobine de modulation, ladite plaque métallique étant disposée sensiblement parallèlement à ladite carte de circuit imprimé.

Avantageusement, ledit radiateur de refroidissement à air comporte une pluralité d'ailettes sensiblement perpendiculaires à ladite plaque métallique et parallèles entre elles.

Conformément à une variante de réalisation, ledit système de conversion comprend des moyens de filtrage comprenant au moins une bobine de filtrage et un condensateur de filtrage par phase de sortie dudit système de conversion.

De préférence, chaque moyen de filtrage comprend au moins une diode en série avec ladite bobine de filtrage.

De manière avantageuse, chaque ensemble formé par ladite diode et ladite bobine de filtrage est monté sur un module de filtrage fixé sur ledit radiateur de refroidissement à air.

Selon une conception, ledit module récupérateur d'énergie électrique comporte trois branches reliées en un point de jonction, avec :

- une première branche comportant un commutateur,
- une deuxième branche comportant une diode,
- une troisième branche comportant une inductance, et
- un condensateur.

Selon la revendication 1, chaque bras de commutation comporte au moins un module de puissance, ledit module de puissance comportant deux entrées aptes à être connectées aux entrées continues dudit système de conversion, deux commutateurs placés en série entre lesdites entrées, et une première sortie disposée entre lesdits deux commutateurs, ladite première sortie étant apte à être connectée à une phase de sortie alternative dudit système de conversion, **[PAGE 5a]**.

Conformément à une option, lesdits modules de puissance sont montés sur ladite carte de circuit imprimé de manière à faire face audit radiateur de refroidissement à air.

où le système de conversion comporte :

une phase d'entrée continue alimentée par une tension par rapport à une masse, une bobine de modulation dont une première extrémité de la bobine de modulation est connectée à la phase d'entrée continue,
le bras de commutation est connectée à une deuxième extrémité de la bobine de modulation, le bras de commutation comporte: deux commutateurs en série sur une branche qui est connectée d'une part à la deuxième extrémité de la bobine de modulation et d'autre part à la masse, deux diodes en série sur une branche qui est connectée au point de jonction entre la deuxième extrémité de la bobine de modulation et la branche comprenant les deux commutateurs, une sortie alternative de courant qui est située au point milieu entre les deux commutateurs,
une capacité de modulation, dont une extrémité est connectée au point de jonction entre les deux diodes du bras de commutation et dont l'autre extrémité est connectée à la sortie du bras de commutation,
une capacité qui est disposée entre l'extrémité non reliée à la bobine de modulation de la branche du bras de commutation qui comprend les deux diodes et la masse,
des moyens de filtrage, en parallèle de la capacité, les moyens de filtrage comprennent: un ensemble formé d'une diode en série avec une bobine de filtrage, cet ensemble est connecté entre l'extrémité de la branche du bras de commutation qui comprend les deux diodes et un point de jonction à l'extrémité de la bobine de filtrage,
une capacité de filtrage connectée entre ce point de jonction et la masse,
un module récupérateur d'énergie électrique, qui est connecté en entrée entre le point de jonction des moyens de filtrage et la masse et qui comporte en sortie une capacité connectée entre la phase d'entrée continue et la masse,
où les modules de puissance, ledit circuit de modulation et ledit module récupérateur d'énergie sont connectés sur une carte de circuit imprimé de telle sorte qu'au moins lesdits modules de puissance et ladite bobine de modulation sont en contact avec un radiateur de refroidissement à air, dans lequel ledit système de conversion comprend des moyens de filtrage comprenant au moins une diode en série avec une bobine de filtrage et un condensateur de filtrage par phase de sortie dudit système de conversion, chaque ensemble formé par ladite diode et ladite bobine de filtrage étant monté sur un module de filtrage fixé sur ledit radiateur de refroidissement à air.

Selon un mode de réalisation, ledit système de conversion comprend une carte de contrôle et/ou une carte d'alimentation connectée à ladite carte de circuit imprimé sur le côté opposé audit radiateur de refroidissement.

En outre, l'invention concerne un procédé de montage d'un système de conversion selon l'une des caractéristiques précédentes. Pour ce procédé, on réalise les étapes suivantes :

a) on assemble lesdits bras de commutation sur ladite carte de circuit imprimé ;
b) on assemble au moins une bobine de modulation sur ledit radiateur de refroidissement à air ;
c) on positionne ladite carte de circuit imprimé de manière à mettre en contact les bras de commutation avec ledit radiateur de refroidissement à air ; et
d) on assemble ledit condensateur de modulation et ledit module récupérateur d'énergie électrique sur ladite carte de circuit imprimé.

Selon un mode de réalisation, on forme au moins un module de filtrage par association en série d'une diode et de ladite bobine de filtrage, et, préalablement à l'étape d'assemblage desdits bras de commutation sur ladite carte de circuit imprimé, on assemble lesdits modules de filtrage sur ledit radiateur de refroidissement à air.

Selon une mise en œuvre, chaque bras de commutation comportant au moins un module de puissance, on assemble chaque module de puissance sur ladite carte de circuit imprimé.

Avantageusement, lesdits assemblages sur ladite carte de circuit imprimé sont réalisés par soudure, vissage et/ou encliquetage.

De préférence, ledit procédé comporte une étape d'assemblage d'une carte de contrôle et/ou d'une carte d'alimentation sur ladite carte de circuit imprimé sur le côté opposé audit radiateur de refroidissement à air.

De plus, l'invention concerne un système moteur comprenant au moins un moyen de stockage d'énergie électrique et une machine électrique triphasée. Le système moteur comporte un système de conversion selon l'une des caractéristiques précédents, pour convertir l'énergie électrique continue dudit moyen de stockage de l'énergie électrique en énergie électrique alternative triphasée pour ladite machine électrique triphasée.

## Présentation succincte des figures

D'autres caractéristiques et avantages du système selon l'invention, apparaîtront à la lecture de la description ci-après d'exemples non limitatifs de réalisations, en se référant aux figures annexées et décrites ci-après.

La figure 1, déjà décrite, illustre un convertisseur DC/AC classique, avec commutation dure, selon l'art antérieur.
La figure 2, déjà décrite, illustre le signal de commutation, la tension et l'intensité dans une phase pour un convertisseur DC/AC selon la conception de la figure 1.
La figure 3, déjà décrite, illustre un convertisseur DC/AC selon l'art antérieur, avec commutation douce.
La figure 4, déjà décrite, illustre le signal de commutation, la tension et l'intensité dans une phase pour un convertisseur DC/AC selon la conception de la figure 3.
La figure 5a illustre un exemple de réalisation du module récupérateur d'énergie électrique pour un convertisseur selon un mode de réalisation de l'invention.
La figure 5b illustre un modèle équivalent résistif au module récupérateur d'énergie électrique de la figure 5a.
La figure 6 illustre un circuit électrique d'une phase du système de conversion selon un mode de réalisation de l'invention.
La figure 7 illustre de manière schématique un module de filtrage selon un mode de réalisation de l'invention.
La figure 8 illustre un schéma électrique d'un module de puissance selon un mode de réalisation de l'invention.
La figure 9 illustre un module de puissance selon un mode de réalisation de l'invention.
La figure 10 illustre un refroidisseur à air selon un mode de réalisation de l'invention.

## Description détaillée de l'invention

La présente invention concerne un système de conversion (convertisseur) DC/AC permettant de convertir une énergie électrique continue en énergie électrique alternative triphasée. Avantageusement, le système de conversion selon l'invention, peut être bidirectionnel (réversible). Ainsi, au moyen du système de conversion selon l'invention, une énergie alternative triphasée peut être convertie en énergie électrique continue.

Classiquement, le système de conversion selon l'invention, comporte trois bras de commutation, une phase d'entrée continue, et trois phases de sorties alternatives. Chaque bras de convertisseur peut comprendre deux commutateurs (interrupteurs) commandés et deux diodes. De manière connue, la commande des commutateurs permet de générer une tension alternative. Les phases de sortie alternatives du système de conversion sont reliées au point milieu de chaque bras de commutation, c'est-à-dire entre les deux commutateurs.

Selon l'invention, le système de conversion comporte un assemblage sur une carte de circuit imprimé, appelée également carte PCB (de l'anglais « Printed Circuit Board »), d'au moins les éléments suivants :

- trois bras de commutation, chaque bras de commutation comporte au moins deux commutateurs pour réaliser la conversion de la puissance continue en puissance alternative,
- un circuit de modulation avec au moins une bobine de modulation et un condensateur de modulation, la bobine de modulation assure la modulation de la variation de courant pour la commutation douce, et le condensateur de modulation assure la modulation de la variation de tension pour la commutation douce, et
- un module de récupération d'énergie électrique, qui permet de récupérer l'énergie disponible ou créée lors de la commutation dite douce, en récupérant l'énergie disponible lors de la commutation douce, et en l'envoyant vers des moyens de stockage d'énergie électrique (par exemple une batterie), connectés aux phases continues du système de conversion.

La carte de circuit imprimé permet notamment de relier électriquement les différents composants (bras de commutation, circuit de modulation, module récupérateur d'énergie électrique), sans l'utilisation de fil électrique. La carte de circuit imprimé est, de préférence, sensiblement plane et peut être de forme sensiblement rectangulaire. La carte de circuit imprimé peut être du type carte multicouche à haute densité de cuivre, de manière à optimiser sa conception. Dans ce cas, les lignes de courant sont incluses dans au moins une couche interne de la carte de circuit imprimé. Ce type de carte multicouche est adapté à des courants élevés. La carte de circuit imprimé peut comporter des fiches pour la connexion des entrées continues et des sorties alternatives du système de conversion. De plus, la carte de circuit imprimé peut comprendre des moyens de fixation pour l'assemblage des différents modules et de la bobine. Ces moyens de fixation peuvent être des orifices, des fentes et/ou des saillies.
Selon l'invention, le système de conversion comporte un radiateur de refroidissement à air, permettant de refroidir au moins une partie des composants électroniques du convertisseur, au moyen d'air apportant du froid au radiateur qui transfère ce froid aux composants électroniques. Le radiateur de refroidissement à air est au moins en contact avec les bras de commutation et la bobine de modulation, lorsqu'ils sont connectés sur la carte de circuit imprimé. En effet le fait qu'on utilise la commutation douce à haute tension, cela implique très peu de pertes, et donc une faible source de chaleur à dissiper, ce qui permet de pouvoir utiliser un refroidissement à air.
De plus, la carte de circuit imprimé, en raison de la haute teneur en cuivre et de sa planéité, peut être facilement refroidie au moyen du radiateur de refroidissement à air.
Selon un mode de réalisation de l'invention, le radiateur de refroidissement à air comprend une plaque métallique, par exemple en acier, sensiblement plane, et au moins une ailette. On appelle plaque un volume ayant une faible épaisseur par rapport aux autres dimensions. La plaque peut avoir sensiblement une forme rectangulaire. L'ailette est placée sur la plaque métallique du côté opposé à la zone de contact avec les composants électroniques. L'ailette permet d'augmenter la surface de contact entre l'air et le radiateur, ce qui assure un meilleur refroidissement. L'ailette est préférentiellement réalisée dans le même matériau que la plaque métallique. L'épaisseur des ailettes peut être sensiblement identique à l'épaisseur de la plaque métallique. De préférence, la plaque métallique du refroidisseur à air est agencée sensiblement parallèlement à la carte de circuit imprimé.
Conformément à une option de réalisation, le radiateur de circuit imprimé peut comprendre des moyens de fixation de bobines de modulation et/ou des moyens de filtrage (par exemple pour les bobines de filtrage ou pour les modules de filtrage décrits dans la suite de la description), ou de tout autre composant du système de conversion. Ces moyens de fixation peuvent être notamment adaptés pour une fixation par vissage et/ou encliquetage ou tout moyen analogue. Pour le mode de réalisation pour lequel ledit radiateur de refroidissement à air comporte une plaque métallique, il peut notamment s'agir d'orifices réalisés dans la plaque métallique.
Selon une mise en œuvre de ce mode de réalisation, le radiateur de refroidissement à air comprend une pluralité d'ailettes, les ailettes étant sensiblement perpendiculaires à la plaque métallique, et parallèles entre elles. Ainsi, les ailettes forment des canaux de passage de l'air favorisant les échanges de chaleur.

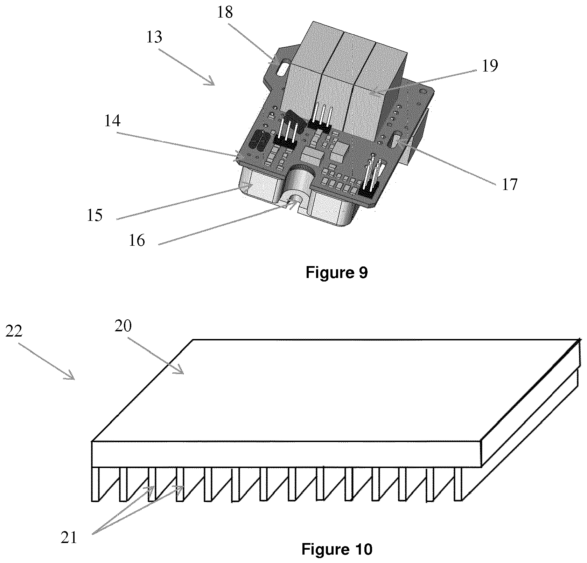

La figure 10 illustre, de manière schématique et non limitative, un radiateur de refroidissement à air selon cette mise en œuvre. Le radiateur de refroidissement à air 22 comporte une plaque plane 20, par exemple en acier. Le radiateur de refroidissement à air 22 comporte en outre une pluralité d'ailettes 21. Les ailettes 21 sont réparties sur un côté de la plaque plane 20. Les ailettes 21 sont sensiblement perpendiculaires à la plaque plane 20, et sensiblement parallèles entre elles. Le côté de la plaque plane 20 sans ailette est destiné à être en contact avec les composants à refroidir, en particulier les bras de commutation et les bobines de modulation. Le côté de la plaque avec les ailettes est destiné à permettre l'échange de chaleur entre l'air et le radiateur de refroidissement à air 22.
Selon un mode de réalisation de l'invention, chaque bras de commutation peut comporter au moins un module de puissance. Chaque module de puissance comprenant notamment des entrées et sorties, deux commutateurs, et deux diodes.
On appelle module, un élément indépendant sous forme de bloc, qui regroupe tous les composants électroniques qui assurent une fonction. Ainsi, chaque module de puissance est un bloc qui comporte des moyens de commutation pour un bras de commutation, et le module de récupération d'énergie électrique est un bloc qui comporte des moyens électroniques permettant la récupération de l'énergie électrique. Cette réalisation sous forme de module, permet un assemblage simplifié et une modularité du système de conversion. En effet, les blocs peuvent être fabriqués séparément, et de manière standard, et le système de conversion est composé de différents modules (blocs) assemblés sur une carte de circuit imprimé. Ainsi, il n'est pas nécessaire d'assembler tous les composants électroniques du système de conversion sur un seul élément. De plus, cette réalisation sous forme de modules, permet de faciliter la maintenance : il est possible de remplacer uniquement un module défectueux sans à avoir à remplacer l'ensemble du convertisseur. Un autre avantage de cette conception est la possibilité d'utiliser des modules standards, qui peuvent être choisis en fonction de l'application souhaitée.

Selon un mode de réalisation, les différents modules (de puissance ou de récupération d'énergie électrique), ainsi que la bobine de modulation sont assemblés sur la carte de circuit imprimé par soudure, vissage et/ou encliquetage (« clipsage ») ou tout moyen analogue. Ces moyens d'assemblage permettent un assemblage rapide.

Les différents modes de réalisation, notamment la constitution des différents modules, décrits dans la description peuvent être combinés, de manière à combiner leurs effets.

Chaque module de puissance sert de bras de commutation du système de conversion. Le module de puissance peut comporter :

- deux entrées, aptes à être connectées aux entrées continues du système de conversion, la première entrée peut être reliée à une tension positive, et la deuxième entrée peut être reliée à la masse,
- deux commutateurs montés en série entre les deux entrées, les commutateurs peuvent être commandés, de manière à fournir un courant de sortie alternatif,
- une sortie, apte à être connectée à une phase de sortie alternative du système de conversion, la sortie est connectée en un point entre les deux commutateurs,
- deux diodes, permettant le passage du courant selon une direction, et
- au moins un condensateur, un premier condensateur dit condensateur de modulation de tension (qui permet la modulation de la variation de tension pour la commutation douce) et éventuellement un deuxième condensateur (qui permet de stocker l'énergie créée qui n'est pas stockée dans le premier condensateur lors de la modulation de la tension).

Un tel module de puissance est compatible avec une large plage de fonctionnement de tension.

Selon un mode de réalisation de l'invention, le module de puissance contient uniquement ces composants électroniques : deux commutateurs, deux diodes, et un ou deux condensateurs. Pour ce mode de réalisation, seul le deuxième condensateur peut être formé par une association en parallèle de plusieurs capacités (par exemple 2 ou 3 capacités).

En outre, le module de puissance est adapté à un système de conversion qui comporte un module récupérateur d'énergie électrique. Le module de puissance peut comprendre une deuxième sortie apte à être connectée au module récupérateur d'énergie électrique. Cette deuxième sortie peut être connectée à une diode.

Selon un mode de réalisation de l'invention, les diodes du module de puissance sont montées en série. Les diodes peuvent être connectées à une première entrée du module de puissance. Par exemple, l'entrée reliée à la tension positive. Dans le cas où le module de puissance comporte une deuxième sortie pour un module récupérateur d'énergie électrique, les diodes sont connectées à cette deuxième sortie.

De plus, le condensateur de modulation de tension peut être monté entre un point compris entre les deux diodes et la première sortie.

En outre, le deuxième condensateur peut être monté entre la deuxième sortie et la deuxième entrée du module de puissance, c'est-à-dire sur l'entrée du module de puissance, sur laquelle les diodes ne sont pas montées, par exemple cette deuxième entrée peut correspondre à la masse.

Conformément à une caractéristique de l'invention, les commutateurs des bras de commutation (et le cas échéant inclus dans les modules de puissance) peuvent être des commutateurs de type MOSFET (acronyme anglais de « Metal Oxide Semiconductor Field Effect Transistor » qui se traduit par transistor à effet de champ à structure métal-oxyde-semi-conducteur) et/ou IGBT (transistor bipolaire à grille isolée de l'anglais « Insulated Gate Bipolar Transistor »), en fonction de la tension d'entrée du bus DC. Pour la haute tension, on peut utiliser des interrupteurs (commutateurs) IGBT. Pour la basse tension, on peut utiliser des interrupteurs MOSFET.

De préférence, les commutateurs peuvent être commandés par une méthode de modulation de largeur d'impulsion (MLI ou en anglais PWM pour « Puise Width Modulation »). Le principe général de cette méthode de modulation est qu'en appliquant une succession d'états discrets pendant des durées bien choisies, on peut obtenir en moyenne sur une certaine durée n'importe quelle valeur intermédiaire.

Pour la modulation des variations de la tension, le premier condensateur de modulation de tension d'un module de puissance peut avoir une valeur comprise entre 4 et 15 nF, de préférence entre 4 et 10 nF.

Le deuxième condensateur d'un module de puissance peut, de préférence, une capacité plus élevée que le premier condensateur. Le deuxième condensateur peut avoir une valeur comprise entre 500 et 5000 nF, de préférence entre 600 et 2500 nF. Selon une variante de réalisation de l'invention, le deuxième condensateur peut être formé de plusieurs capacités associées en parallèle et/ou en série. De manière avantageuse, pour limiter l'encombrement, le deuxième condensateur peut être formé de trois capacités identiques (de même capacité) associées en parallèle.

Avantageusement, le module de puissance se présente sous la forme d'un bloc, de manière à faciliter son assemblage, sa compacité et sa standardisation. Le bloc peut comprendre un support, une plaque comprenant un circuit imprimé, et les composants électroniques (commutateurs, diodes, condensateurs) du module de puissance. La plaque peut être sous la forme d'un circuit imprimé. Les composants électroniques sont montés sur la plaque. La plaque est montée sur le support. Le bloc peut être agencé de manière à être monté sur la carte de circuit imprimé d'un système de conversion. Le bloc peut avoir une forme sensiblement parallélépipédique.

Conformément à une variante de réalisation de l'invention, le bloc peut comporter plusieurs moyens de fixation sur une carte d'un système de conversion. Les moyens de fixation peuvent être notamment au moins une encoche prévue pour le passage d'une vis. L'encoche peut être prévue dans le support et/ou la plaque du bloc. L'encoche peut être de forme sensiblement oblongue. Les moyens de fixation peuvent également comprendre au moins une fente ou une saillie, de manière à permettre une fixation par encliquetage (« clipsage ») ou pour permettre une mise en position du bloc.

Le bloc peut également comprendre des moyens de fixation pour la fixation de plusieurs modules entre eux, de manière à pouvoir associer plusieurs modules entre eux, notamment pour le cas où les courants sont élevés, ce qui permet de réaliser le bras de commutation d'un système de conversion sans employer des composants onéreux ayant des caractéristiques spécifiques élevées.

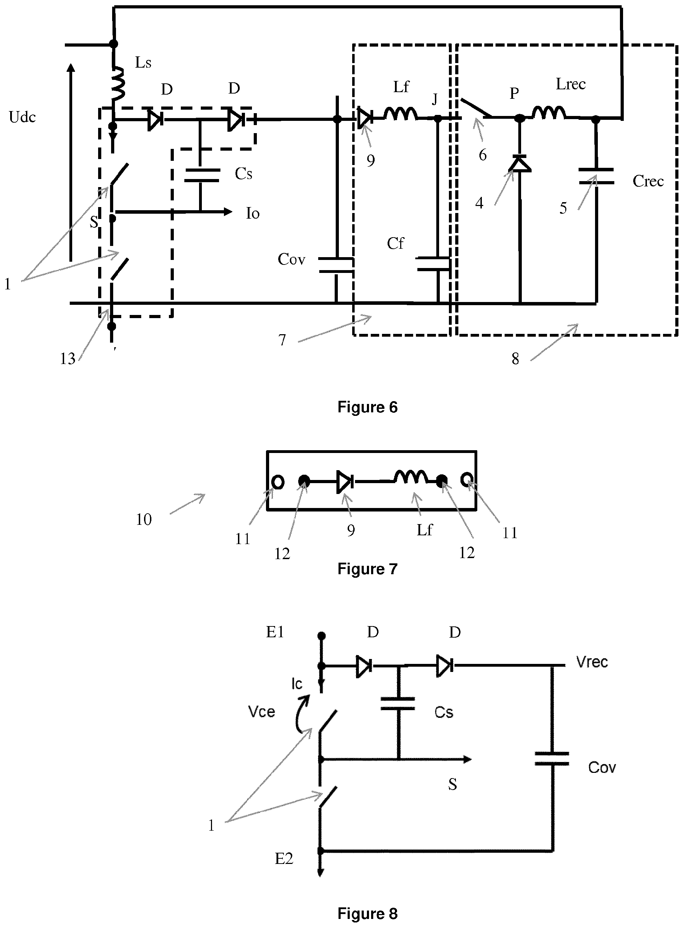

La figure 8 illustre, de manière non limitative, un schéma électrique d'un module de puissance selon un mode de réalisation de l'invention. Le module de puissance comporte deux entrées E1 et E2 destinées à être connectées aux entrées continues du système de conversion. L'entrée E1 peut correspondre à l'entrée de tension positive, et l'entrée E2 peut correspondre à la masse. Entre les deux entrées E1 et E2, deux commutateurs commandés 1 sont montées en série. Entre les deux commutateurs 1, la sortie S est destinée à être connectée à une phase de sortie du système de conversion. Deux diodes D sont montées en série entre l'entrée E1 et la deuxième sortie Vrec, qui est apte à être connectée à un module récupérateur d'énergie électrique. Un premier condensateur Cs, destinée à la modulation de tension, est connecté en un point entre les deux diodes D et la première sortie S. Un deuxième condensateur Cov est connecté entre la deuxième sortie Vrec et la deuxième entrée E2.

La figure 9 illustre, schématiquement et de manière non limitative, un module de puissance selon un mode de réalisation de l'invention. Le module a sensiblement la forme d'un bloc 13. Le bloc 13 comporte une plaque 14, sous forme d'un circuit imprimé sur laquelle sont montées différents composants électroniques. La plaque 14 a sensiblement la forme d'un rectangle. La plaque 14 est montée sur un support 15. Le support 15 a sensiblement la forme d'un parallélépipède rectangle. La plaque 14 et le support 15 comportent plusieurs moyens de fixation : une encoche 16 prévue pour le passage d'une vis, et deux fentes 17 et 18 pour une fixation par encliquetage et/ou pour une mise en position du bloc. Des composants électroniques (représentés schématiquement) sont montées sur la plaque 14 du côté opposé au support 15. Parmi les composants électroniques, le deuxième condensateur Cov est formé de trois condensateurs 19 associés en parallèle.

Selon l'invention, le système de conversion comporte en outre un circuit de modulation de tension et d'intensité. Le circuit de modulation de tension et d'intensité permet une commutation douce (« soft switching »), ce qui permet de limiter les pertes par commutation, de limiter les dépassements de tension et de courant sur les commutateurs. Le circuit de modulation comporte une bobine de modulation par phase, qui module la variation de courant, et un condensateur de modulation par phase, pour moduler la variation de tension. La bobine de modulation peut être connectée directement sur la carte de circuit imprimé. Afin de maximiser la densité de cuivre dans l'enroulement de la bobine, l'enroulement peut être constitué par des couches de cuivre obtenues par gravure chimique et isolées par l'application d'un revêtement isolant, de manière à minimiser l'effet de peau qui pourrait avoir un effet nuisible pour les fréquences élevés. Chaque condensateur de modulation peut être inclus dans un des modules de puissance.

Selon un mode de réalisation de l'invention, le circuit de modulation comporte une bobine de modulation qui relie une phase d'entrée continue du système de commutation et les bras de commutation.

Selon une option de réalisation de l'invention, chaque bobine de modulation peut être fixée sur le radiateur de refroidissement à air, et, une fois le système de conversion monté, être connecté électriquement avec la carte de circuit imprimé. La fixation de la bobine de modulation directement sur le radiateur de refroidissement à air permet un refroidissement optimal de la bobine de modulation.

Selon l'invention, le système de conversion comporte en outre un module récupérateur d'énergie électrique. Avantageusement, le module de récupération d'énergie électrique ne comprend pas de résistance. Ainsi, le système de conversion ne comporte pas de résistance, dans laquelle de l'énergie est dissipée pour l'art antérieur. Au contraire, le module récupérateur d'énergie électrique, qui remplace la résistance, permet de récupérer l'énergie disponible ou créée lors de la commutation dite douce, en récupérant l'énergie disponible lors de la commutation douce et en l'envoyant vers des moyens de stockage d'énergie électrique (par exemple une batterie), connectés aux phases continues du système de conversion. Le module de récupération d'énergie électrique a pour fonction de décharger les circuits de protection des commutateurs et de rendre cette énergie disponible sur le bus continu. Ainsi, les pertes électriques sont fortement réduites. Le module récupérateur d'énergie électrique est relié au bras de commutation et au circuit de modulation.

Selon une conception possible de l'invention, le module récupérateur d'énergie électrique peut comprendre au moins une inductance, au moins une diode, au moins un condensateur et au moins un commutateur. Le commutateur est commandé de manière à autoriser la récupération d'énergie et son transfert vers les moyens de stockage d'énergie électrique. Avantageusement, le circuit de récupération peut être réalisé avec une topologie abaisseur (en anglais « buck »).

Selon une variante de réalisation de l'invention, le module récupérateur d'énergie électrique peut comporter trois branches reliées en un point de jonction avec :

- une première branche comportant un commutateur,
- une deuxième branche comportant une diode, et
- une troisième branche comportant une inductance.

Ainsi, la carte du circuit imprimé du système de conversion peut être modifiée de manière spécifique pour utiliser la conception d'un convertisseur de commutation douce compatible avec des fréquences de commutation élevées, tout en minimisant les pertes dues au circuit passif rajouté pour assurer le fonctionnement du circuit de modulation.

Le module de récupération d'énergie électrique peut être réalisé sous la forme d'un bloc comprenant des moyens de fixation à la carte de circuit imprimé. La fixation peut être réalisée par soudure, vissage, encliquetage ou tout moyen analogue. Dans ce but, les moyens de fixation à la carte de circuit imprimé peuvent être au moins un orifice, par exemple pour le passage d'une vis, au moins une saillie, au moins une fente etc.

La figure 5a représente, de manière schématique et non limitative, un tel module récupérateur d'énergie électrique. Le module récupérateur d'énergie électrique comporte trois branches reliées en un point de jonction P, avec :

- une première branche avec un commutateur 6,
- une deuxième branche comportant une diode 4 (dans laquelle circule un courant iL en fonction de la tension à ses bornes), et
- une troisième branche comportant une inductance Lrec.

Sur la figure 5a, le condensateur 5 représente la capacité des moyens de stockage d'énergie électrique (batterie) et n'est pas un composant du module récupérateur. Le condensateur 5 est placé entre l'inductance Lrec et la masse.

De plus, le condensateur 3 représente la capacité Crec, et c'est un composant du module récupérateur. Le condensateur 3 est placé entre le commutateur et la masse.

La diode 4 est placée entre le point de jonction des trois branches et la masse.

En pilotant le commutateur (son rapport cyclique), on peut piloter le courant iL qui circule entre Vrec et Udc (le courant envoyé à la batterie).

Ainsi, en considérant l'ensemble formé par le module récupérateur et le condensateur des moyens de stockage d'énergie électrique, l'ensemble est formé de trois branches parallèles, placées entre le point P et la masse, avec :

- une première branche comportant le commutateur 6 et le condensateur 3,
- une deuxième branche comportant une diode 4, et
- une troisième branche comportant l'inductance Lrec et la capacité 5 des moyens de stockage de l'énergie électrique.

Quand le commutateur est fermé, la diode est dans un mode bloquée et le courant iL qui circule dans la bobine Lrec (représenté dans la figure 5a) est égal à $\frac{V_{rec} - U_{dc}}{L_{rec}}$

Quand le commutateur est ouvert, la diode est en mode passant et le courant iL qui circule dans la bobine Lrec (représenté dans la figure 5a) est égal à $\frac{-U_{dc}}{L_{rec}}$ .

Ainsi, en pilotant le temps d'ouverture et de fermeture du commutateur, on peut piloter la valeur moyenne du courant iL, et avoir un fonctionnement équivalent d'un circuit résistif.

La figure 5b représente, de manière non limitative, un schéma électrique équivalent du module récupérateur d'énergie électrique illustré à la figure 5a. Ainsi, le module récupérateur d'énergie électrique est équivalent à une résistance équivalente Req, dans laquelle circule un courant iL, mais sans dissipation de l'énergie électrique.

Pour cette variante de réalisation, le courant moyen dans ce circuit peut être exprimé sous la forme suivante :

$$\overline{i} \cong \frac{V_{rec} - U_{dc}}{L_{rec}}\frac{T}{2} = \frac{V_{rec} - U_{dc}}{2 * L_{rec} * Fsw} \cong \frac{V_{rec} - U_{dc}}{Req}$$

avec :

- T la période de commutation du commutateur,
- Vrec la tension de récupération,
- Udc la tension de la phase d'entrée continue,
- Lrec l'inductance du module récupérateur,
- Req la résistance équivalente, et
- Fsw représente la fréquence de commutation des interrupteurs.

De préférence, un tel module récupérateur d'énergie est monté dans le système de conversion équipé du circuit de modulation, de telle sorte que le module récupérateur d'énergie électrique est disposé entre une phase d'entrée continue du système de conversion et la jonction entre le bras de commutation et le condensateur du circuit de modulation. Pour le mode de réalisation de la figure 5a, le module récupérateur d'énergie électrique peut être connecté de telle sorte que :

- le point du module récupérateur relié à ladite phase d'entrée continue (de tension Udc) du système de conversion correspond au point de la troisième branche du module récupérateur entre l'inductance Lrec et le deuxième condensateur 5 (ce condensateur est la capacité de la batterie), et
- le point du module récupérateur relié à la jonction entre le bras de commutation (de tension Vrec) et le condensateur du circuit de modulation correspond au point de la première branche du module récupérateur entre le commutateur 6 et le premier condensateur 3.

Selon un mode de réalisation de l'invention, le module récupérateur d'énergie électrique peut être monté sur la carte de circuit imprimé de manière à être en contact avec le radiateur de refroidissement à air. Ainsi, il est possible de refroidir les composants du module récupérateur d'énergie électrique, en particulier l'inductance de ce module.

Selon l'invention, le système de conversion comporte en outre des moyens de filtrage. Les moyens de filtrage permettent de lisser les tensions et les courants dans les phases de sortie alternative. De manière connue, les moyens de filtrage comportent, pour chaque phase de sortie du convertisseur, une bobine de filtrage et un condensateur de filtrage. En outre, les moyens de filtrage peuvent comporter une diode associée en série à la bobine de filtrage. De cette manière, il est possible de réduire l'inductance de la bobine des moyens de filtrage, ce qui a pour effet de réduire l'encombrement du système de conversion. En effet, sans la diode, et pour garantir un filtrage optimal, il est nécessaire d'avoir une bobine de filtrage de plusieurs centaines de micro henry, qui peut représenter un encombrement d'environ 10 cm sur 5 cm, alors qu'avec la diode, la bobine de filtrage peut avoir une valeur comprise entre 0,5 et 50 micro henry, qui peut représenter un encombrement d'environ 1 cm sur 1 cm. Un autre effet de cette réduction de l'inductance de la bobine est la diminution de la chaleur générée, ce qui permet de simplifier le refroidissement du système de conversion.

Conformément à une mise en œuvre de l'invention, chaque moyen de filtrage est disposé entre un bras de commutation et le module récupérateur d'énergie électrique du système de conversion.

De préférence, la diode en série avec la bobine de filtrage au sein des moyens de filtrage est une diode du type Schottky (qui est une diode qui a un seuil de tension directe très bas et un temps de commutation très court.). La diode est placée de manière à permettre le passage du courant depuis le bras de commutation vers le module récupérateur d'énergie électrique. La diode permet de réduire voire d'éliminer les pics de tension aux bornes du module récupérateur d'énergie électrique. De préférence, la diode est placée en amont de la bobine de filtrage dans le sens de circulation du courant.

Selon un mode de réalisation de l'invention, l'ensemble formé par la bobine et la diode des moyens de filtrage est monté sur un module de filtrage indépendant. On rappelle qu'un module est un élément indépendant sous forme de bloc, qui regroupe tous les composants électroniques qui assurent une fonction. Cette réalisation sous forme de module, permet un assemblage simplifié et une modularité du système de conversion. De préférence, le module de filtrage peut être monté sur une carte de circuit imprimé, qui comporte les bras de commutation, le circuit de modulation et le module récupérateur d'énergie électrique.

Pour ce mode de réalisation, le module de filtrage peut être fixé sur le radiateur de refroidissement à air, et être connecté à la carte de circuit imprimé, lorsque le système de conversion est assemblé. La fixation du module de filtrage directement sur le radiateur de refroidissement à air permet un refroidissement optimal du module de filtrage, en particulier de la bobine de filtrage. L'utilisation d'une diode en série avec la bobine de filtrage permet de réduire l'inductance de la bobine de filtrage. Ainsi, la bobine de filtrage chauffe moins, ce qui nécessite un refroidissement moins conséquent qu'une bobine ayant une inductance élevée. De cette manière, il est possible de réaliser un refroidissement efficace des moyens de filtrage avec un radiateur de refroidissement à air.

Selon une mise en œuvre de l'invention, le système de conversion peut comprendre un carter, dans lequel est monté l'assemblage (radiateur de refroidissement à air et carte de circuit imprimé avec notamment les bras de commutation, le circuit de modulation, le module récupérateur, etc.). Le carter peut comprendre plusieurs orifices : notamment deux pour les entrées continues, pour permettre la connexion avec le système de stockage d'énergie électrique, et trois pour les sorties alternatives, pour permettre la connexion avec les phases de la machine électrique. Avantageusement, le carter peut avoir une forme sensiblement parallélépipédique. De plus, le carter peut comprendre des moyens pour positionner les différents modules avant leur assemblage sur la carte de circuit imprimé. Le carter peut comporter en outre des emplacements pour les différents circuits et cartes pouvant faire partie du système de conversion.

La figure 6 illustre, de manière schématique et non limitative, un circuit électrique d'un système de conversion selon un mode de réalisation de l'invention (avec une diode en série avec la bobine de filtrage). Pour ne pas surcharger la figure, celle-ci ne représente le circuit avec un seul bras de commutation pour une seule phase de sortie triphasée du système de conversion, ce circuit est répété pour les deux autres phases. Le système de conversion comporte :

- une phase d'entrée continue alimentée par une tension Udc, par rapport à la masse,
- une bobine de modulation Ls, dont une première extrémité est connectée à la phase d'entrée continue,
- un bras de commutation 13, connectée à une deuxième extrémité de la bobine de modulation Ls, le bras de commutation 13 comporte :

  ○ deux commutateurs 1 en série sur une branche, cette branche est connectée d'une part à la deuxième extrémité de la bobine de modulation Ls et d'autre part à la masse,
  ○ deux diodes D en série sur une branche, qui est connectée au point de jonction entre la deuxième extrémité de la bobine de modulation Ls, et la branche comprenant les deux commutateurs 1,
  ○ une sortie alternative S de courant Io, qui est située au point milieu entre les deux commutateurs 1,

- une capacité Cs de modulation, dont une extrémité est connectée au point de jonction entre les deux diodes D du bras de commutation 13, et dont l'autre extrémité est connectée à la sortie S du bras de commutation 13,
- une capacité Cov qui permet de stocker une partie de l'énergie électrique, la capacité Cov est disposée entre l'extrémité (non reliée à la bobine de modulation Ls) de la branche du bras de commutation 13 qui comprend les deux diodes D et la masse,
- des moyens de filtrage 7, en parallèle de la capacité Cov, c'est-à-dire également connectés entre l'extrémité de la branche du bras de commutation 13 qui comprend les deux diodes D et la masse, les moyens de filtrage comprennent :

  ○ un ensemble formé d'une diode 9 en série avec une bobine de filtrage Lf, servant au filtrage, cet ensemble est connecté entre l'extrémité de la branche du bras de commutation 13 qui comprend les deux diodes D et un point de jonction J à l'extrémité de la bobine de filtrage Lf,
  ○ une capacité de filtrage Cf, connectée entre ce point de jonction J et la masse,

- un module récupérateur d'énergie électrique 8, identique à celui illustré à la figure 5a, et qui comporte trois branches reliées en un point de jonction P, avec :

  ○ une première branche avec un commutateur 6, l'extrémité de la première branche est connectée au point de jonction J des moyens de filtrage 7,
  ○ une deuxième branche comportant une diode 4, l'extrémité de la deuxième branche est connectée à la masse, et
  ○ une troisième branche comportant une inductance Lrec, l'extrémité de la troisième branche est connectée à la phase d'entrée continue du système de conversion, et

- une capacité 5, notée Crec, connectée entre l'extrémité de la troisième branche du module récupérateur 8 d'énergie électrique (c'est-à-dire connectée à la bobine Lrec) et la masse.

Pour le mode de réalisation illustré en figure 6, on peut utiliser, de manière illustrative et non limitative, des composants ayant les valeurs suivantes :

- Ls ∼= 300 microH,
- Cs ∼= 6.8 nF,
- Cov ∼= 2820 nF (6*470 nF : formé de six capacités en parallèle),
- Vrec ∼= 1.15 Vbus,
- Lrec = 21 microH,
- Crec = 27.2 nF (6.8 nF x4 : formé de quatre capacités en parallèle),
- Lf = 2.2 microH,
- Cf =10μF + 470nF = 10.47 μF, et
- type de commutateur : IGBT.

La figure 7 illustre de manière schématique et non limitative, un module de filtrage selon un mode de réalisation de l'invention. Le module de filtrage 10 comporte un support sur lequel sont montés une diode 9 en série avec une bobine de filtrage Lf. Aux extrémités de la diode 9 et de la bobine Lf, le module de filtrage comporte des moyens de connexion électrique 12 pour permettre une connexion électrique avec les autres éléments du convertisseur, notamment au moyen de la carte de circuit imprimé. De plus, le support du module de filtrage 10 comporte des orifices 11 pour le montage sur un radiateur de refroidissement à air. Le montage peut être réalisé par vissage, encliquetage (« clipsage »), soudure, ou tout moyen analogue.

Selon un mode de réalisation de l'invention, le système de conversion peut comporter une carte de contrôle. Selon un exemple la carte de contrôle peut être basée sur un DSP de Texas Instrument, et peut exécuter les fonctions suivantes :

- le conditionnement des lectures analogiques,
- la gestion des entrées et sorties,
- la gestion des protections, par exemple grâce à des moyens permettant de couper le système de conversion en cas de surtension ou de sur-courant, et
- la gestion de la modulation de la largeur d'impulsion (MLI ou PWM) pour les commutateurs des bras de commutation.

Selon une mise en œuvre de l'invention, le système de conversion peut comporter un circuit de mesure. Le circuit de mesure peut être formé d'une carte, pouvant comprendre plusieurs sous-cartes. Le circuit de mesure permet de mesurer les grandeurs nécessaires pour le contrôle, en particulier les tensions et/ou les courants de phase, et/ou la tension et le courant de bus, et/ou la tension du module récupérateur d'énergie électrique. En outre, le système de conversion selon l'invention peut comprendre au moins un capteur de courant placé sur la carte de circuit imprimé. Chaque capteur de courant peut être relié au circuit de mesure.

De plus, le système de conversion selon l'invention peut comprendre une carte d'alimentation, qui peut générer une onde carrée haute fréquence (par exemple 18 V à 130kHz), qui peut être utilisée par chaque carte (par exemple, la carte de contrôle, les sous-cartes du circuit de mesure) pour créer des niveaux de tension.

Selon un exemple non limitatif de réalisation, le système de conversion peut comprendre de haut en bas (selon une position horizontale du système de conversion) :

- un premier étage avec une carte d'alimentation et une carte de contrôle,
- un deuxième étage formé par la carte de circuit imprimé qui comporte :

  ∘ sur son côté supérieur (faisant face au premier étage) différents condensateurs, notamment des condensateurs de modulation, des condensateurs de bus, condensateurs de stockage notés Cov, etc.,
  ∘ sur son côté inférieur (faisant face au troisième étage) les modules de puissance, et le module récupérateur d'énergie électrique,

- un troisième étage formé par le radiateur de refroidissement à air avec sur son côté supérieur (faisant face au deuxième étage) les modules de filtrage et les bobines de modulation.

L'ensemble des composants étant connectés ensemble de manière à réaliser la conversion de la puissance électrique. Avec cette réalisation, toutes les bobines sont en contact avec le radiateur de refroidissement à air, ce qui favorise le contrôle de leur température.

Le système de conversion selon l'invention permet de piloter des machines électriques, pour tous types d'application, en particulier pour des machines électriques tournant à de très hautes vitesses avec un rendement de l'onduleur (convertisseur) élevé.

Le convertisseur selon l'invention peut être prévu pour une utilisation embarquée, en particulier au sein d'un véhicule, notamment terrestre, aéronautique ou naval.

Le système de conversion selon l'invention peut également être utilisé dans les systèmes non embarqués de production d'énergie électrique, tels que des turbines, des micro-turbines ou des éoliennes.

En outre, la présente invention concerne un système moteur comprenant au moins un moyen de stockage d'énergie électrique, par exemple une batterie, et une machine électrique triphasée, par exemple une machine électrique à aimants permanents. Le système moteur comporte un système de conversion selon un des modes de réalisation décrits ci-dessus (ou selon l'une quelconque des combinaisons des modes de réalisation décrits), pour convertir l'énergie électrique continue du moyen de stockage de l'énergie électrique en énergie électrique alternative triphasée pour la machine électrique, et éventuellement inversement. Ainsi, grâce au système de conversion, la machine électrique peut être pilotée, tout en limitant les pertes électriques. En outre, si le système de conversion est bidirectionnel (réversible), alors il est également possible de stocker (par exemple dans une batterie) une énergie électrique engendrée par la rotation de la machine électrique.

En outre, la présente invention concerne un procédé d'assemblage d'un système de conversion selon l'un des modes de réalisation décrits précédemment, ou l'une quelconque des combinaisons des modes de réalisation précédemment décrits. Le procédé d'assemblage comporte les étapes suivantes :

a) on assemble, les bras de commutation, par exemple sous forme de module de puissance, sur la carte de circuit imprimé, par exemple par soudure, vissage, encliquetage, ou tout moyen analogue ;
b) on assemble chaque bobine de modulation (une par phase) sur le radiateur de refroidissement à air ;
c) on positionne la carte de circuit imprimé de manière à mettre en contact les bras de commutation avec le radiateur de refroidissement à air, et à connecter électriquement les bobines de modulation avec la carte de circuit imprimé; et
d) on assemble le condensateur de modulation et le module récupérateur d'énergie électrique sur la carte de circuit imprimé.

Les étapes a), et b) peuvent être réalisées selon un ordre quelconque ou simultanément. En outre, les étapes c) et d) peuvent être réalisées selon l'ordre inverse.

Selon un mode de réalisation de l'invention, on forme au moins un module de filtrage par association en série d'une diode et d'une bobine de filtrage, sur un support, par exemple tel qu'illustré en figure 7, et on assemble, par exemple par soudure, vissage, encliquetage, ou tout moyen analogue, le module de filtrage sur le radiateur de refroidissement à air. Une fois le convertisseur assemblé, les moyens de filtrage sont connectés électriquement avec la carte de circuit imprimé. Cette étape d'assemblage de modules de filtrage sur le radiateur de refroidissement à air peut être préalable aux étapes a) et b), ou simultanée à l'étape b). L'utilisation d'une diode en série avec la bobine de filtrage permet de réduire l'inductance de la bobine de filtrage. Ainsi, la bobine de filtrage chauffe moins, ce qui nécessite un refroidissement moins conséquent qu'une bobine ayant une inductance élevée. De cette manière, il est possible de réaliser un refroidissement efficace des moyens de filtrage au moyen d'un radiateur de refroidissement à air.

Conformément à une mise en œuvre de l'invention, on réalise un bras de commutation au moyen d'au moins un module de puissance, et on assemble chaque module de puissance sur la carte de circuit imprimé, par exemple par soudure, vissage, encliquetage, ou tout moyen analogue. Les modules de puissance peuvent être conformes aux modes de réalisation des figures 8 et 9. Les modules de puissances sont agencés sur la carte de circuit imprimé de manière à être en contact avec le radiateur de refroidissement à air. Ainsi, la chaleur générée par les bras de commutation (par exemple les commutateurs) peut être limitée grâce au refroidissement permis par le radiateur de refroidissement à air.

Selon une conception de l'invention, on assemble le module récupérateur d'énergie électrique sur la carte de circuit imprimé, par exemple par soudure, vissage, encliquetage, ou tout moyen analogue, de manière à ce que le module récupérateur d'énergie électrique soit en contact avec le radiateur de refroidissement à air. Ainsi, il est possible de refroidir les composants du modulé récupérateur d'énergie électrique.

En outre, le procédé peut comprendre une étape d'assemblage de différents condensateurs, notamment des condensateurs de modulation, des condensateurs de bus, des condensateurs de stockage notés Cov, etc., sur la carte de circuit imprimé, du côté opposé de la carte de circuit imprimé, sur lequel les différents modules sont assemblés, donc sur le côté opposé au radiateur de refroidissement à air.

Par ailleurs, le procédé peut comprendre au moins une étape pour l'installation d'au moins un des éléments suivants : un circuit de mesure, une carte de contrôle, une carte d'alimentation. Ces cartes peuvent être assemblées sur la carte du circuit imprimé du côté opposé au radiateur de refroidissement à air.

**Revendications**

**1.** Système de conversion d'une puissance électrique continue en puissance électrique alternative triphasée compre-

ЕР 3 476 036 B1

nant trois bras de commutation (A, B, C), un circuit de modulation des variations de tension et d'intensité, et un module récupérateur d'énergie électrique sous forme d'un bloc, ledit circuit de modulation comprenant un condensateur de modulation (Cs) et une bobine de modulation (Ls) par phase de sortie dudit système de conversion, chaque bras de commutation comportant au moins un module de puissance sous forme de bloc, ledit module de puissance comportant deux entrées (E1, E2) aptes à être connectées aux entrées continues dudit système de conversion, deux commutateurs (1) placés en série entre lesdites entrées (E1, E2), et une première sortie (S) disposée entre lesdits deux commutateurs (1), ladite première sortie (S) étant apte à être connectée à une phase de sortie alternative dudit système de conversion,
où le système de conversion comporte :

une phase d'entrée continue alimentée par une tension (Udc) par rapport à une masse, une bobine de modulation (Ls) dont
une première extrémité de la bobine de modulation (Ls) est connectée à la phase d'entrée continue,
le bras de commutation (13) est connectée à une deuxième extrémité de la bobine de modulation (Ls), le bras de commutation (13) comporte: deux commutateurs (1) en série sur une branche qui est connectée d'une part à la deuxième extrémité de la bobine de modulation (Ls) et d'autre part à la masse, deux diodes (D) en série sur une branche qui est connectée au point de jonction entre la deuxième extrémité de la bobine de modulation (Ls) et la branche comprenant les deux commutateurs (1), une sortie alternative (S) de courant qui est située au point milieu entre les deux commutateurs (1),
une capacité (Cs) de modulation, dont une extrémité est connectée au point de jonction entre les deux diodes (D) du bras de commutation (13) et dont l'autre extrémité est connectée à la sortie (S) du bras de commutation (13),
une capacité (Cov) qui est disposée entre l'extrémité non reliée à la bobine de modulation (Ls) de la branche du bras de commutation (13) qui comprend les deux diodes (D) et la masse,
des moyens de filtrage (7), en parallèle de la capacité (Cov), les moyens de filtrage comprennent :

un ensemble formé d'une diode (9) en série avec une bobine de filtrage (Lf), cet ensemble est connecté entre l'extrémité de la branche du bras de commutation (13) qui comprend les deux diodes (D) et un point de jonction (J) à l'extrémité de la bobine de filtrage (Lf),
une capacité de filtrage (Cf) connectée entre ce point de jonction (J) et la masse,
un module récupérateur d'énergie électrique (8), qui est connecté en entrée entre le point de jonction (J) des moyens de filtrage (7) et la masse et qui comporte en sortie une capacité (Crec) connectée entre la phase d'entrée continue et la masse,
où les modules de puissance, ledit circuit de modulation et ledit module récupérateur d'énergie sont connectés sur une carte de circuit imprimé de telle sorte qu'au moins lesdits modules de puissance et ladite bobine de modulation (Ls) sont en contact avec un radiateur de refroidissement à air (22), dans lequel ledit système de conversion comprend des moyens de filtrage comprenant au moins une diode (9) en série avec une bobine de filtrage (Lf) et un condensateur de filtrage (Cf) par phase de sortie dudit système de conversion, chaque ensemble formé par ladite diode (9) et ladite bobine de filtrage (Lf) étant monté sur un module de filtrage (10) fixé sur ledit radiateur de refroidissement à air.

2. Système selon la revendication 1, dans lequel ledit radiateur de refroidissement à air comprend une plaque métallique (20) sensiblement plane, et au moins une ailette (21) sur le côté de ladite plaque métallique (20) opposé au côté en contact avec lesdits bras de commutation (A, B, C) et ladite bobine de modulation (Ls), ladite plaque métallique (20) étant disposée sensiblement parallèlement à ladite carte de circuit imprimé.

3. Système selon la revendication 2, dans lequel ledit radiateur de refroidissement à air (22) comporte une pluralité d'ailettes (21) sensiblement perpendiculaires à ladite plaque métallique (20) et parallèles entre elles.

4. Système selon l'une des revendications précédentes, dans lequel ledit module récupérateur d'énergie électrique comporte trois branches reliées en un point de jonction (P), avec :

- une première branche comportant un commutateur (6),
- une deuxième branche comportant une diode (4),
- une troisième branche comportant une inductance (Lrec), et
- un condensateur (3).

5. Système selon l'une des revendications précédentes, dans lequel ledit système de conversion comprend une carte de contrôle et/ou une carte d'alimentation connectée à ladite carte de circuit imprimé sur le côté opposé audit radiateur de refroidissement (22).

6. Procédé de montage d'un système de conversion selon l'une des revendications précédentes, **caractérisé en ce qu'**on réalise les étapes suivantes :

   a) on assemble lesdits bras de commutation (A, B, C) sur ladite carte de circuit imprimé ;
   b) on assemble au moins une bobine de modulation (Ls) sur ledit radiateur de refroidissement à air (22) ;
   c) on positionne ladite carte de circuit imprimé de manière à mettre en contact les bras de commutation (A, B, C) avec ledit radiateur de refroidissement à air (22) ; et
   d) on assemble ledit condensateur de modulation (Cs) et ledit module récupérateur d'énergie électrique sur ladite carte de circuit imprimé,

   dans lequel on forme au moins un module de filtrage (10) par association en série d'une diode (9) et de ladite bobine de filtrage (Lf), et, préalablement à l'étape d'assemblage desdits bras de commutation (A, B , C) sur ladite carte de circuit imprimé, on assemble lesdits modules de filtrage (10) sur ledit radiateur de refroidissement à air (22).

7. Procédé selon la revendication 6, dans lequel chaque bras de commutation comportant au moins un module de puissance (13), on assemble chaque module de puissance sur ladite carte de circuit imprimé.

8. Procédé selon l'une des revendications 6 ou 7, dans lequel lesdits assemblages sur ladite carte de circuit imprimé sont réalisés par soudure, vissage et/ou encliquetage.

9. Procédé selon l'une des revendications 6 à 8, dans lequel ledit procédé comporte une étape d'assemblage d'une carte de contrôle et/ou d'une carte d'alimentation sur ladite carte de circuit imprimé sur le côté opposé audit radiateur de refroidissement à air.

10. Système moteur comprenant au moins un moyen de stockage d'énergie électrique et une machine électrique triphasée (M), **caractérisé en ce que** le système moteur comporte un système de conversion selon l'une des revendications 1 à 5, pour convertir l'énergie électrique continue dudit moyen de stockage de l'énergie électrique en énergie électrique alternative triphasée pour ladite machine électrique triphasée (M).

**Patentansprüche**

1. System zur Umwandlung von kontinuierlicher elektrischer Leistung in dreiphasige elektrische Wechselleistung mit drei Schaltarmen (A, B, C), einer Schaltung zum Modulieren von Spannungs- und Intensitätsänderungen und einem Modul zur Rückgewinnung elektrischer Leistung, Modulation genannt, die eine Modulation umfasst Kondensator (Cs) und eine Modulationsspule (Ls) pro Ausgangsphase des Umwandlungssystems, wobei jeder Schaltzweig (A, B, C) mindestens ein Leistungsmodul in Form eines Blocks umfasst, wobei das Leistungsmodul zwei Eingänge (E1, E2), die an kontinuierliche Eingänge des Umwandlungssystems angeschlossen werden kann, zwei Schalter (1), die in Reihe innerhalb der Eingänge (E1, E2) angeordnet sind, und ein erster Ausgang (S), der innerhalb der beiden Schalter (1) angeordnet ist, wobei der erste Ausgang (S), der angepasst ist, um mit einer alternativen Ausgangsphase des Umwandlungssystems verbunden zu werden,
   wobei das Umrechnungssystem Folgendes umfasst:

   eine kontinuierliche Eingangsphase, die von einer Spannung (Udc) in Bezug auf Masse gespeist wird, eine Modulationsspule (Ls), wobei
   ein erstes Ende der Modulationsspule (Ls) mit der kontinuierlichen Eingangsphase verbunden ist,
   der Schaltarm (13) ist mit einem zweiten Ende der Modulationsspule (Ls) verbunden, der Schaltarm (13) umfasst:
   zwei Schalter (1) in Reihe an einem Zweig, der einseitig mit dem zweiten Ende des Modulationsspule (Ls) und auf der anderen Seite an Masse, zwei Dioden (D) in Reihe an einem Zweig, der an der Verbindungsstelle zwischen dem zweiten Ende der Modulationsspule (Ls) und dem Zweig mit den beiden Schaltern (1) angeschlossen ist, einen alternativen Stromausgang (S), der sich in der Mitte zwischen den beiden Schaltern (1) befindet,
   eine Modulationskapazität (Cs), deren eines Ende mit dem Verbindungspunkt zwischen den beiden Dioden (D) des Schaltzweigs (13) verbunden ist und deren anderes Ende mit dem Ausgang (S) des Schaltzweigs verbunden ist (13),

eine Kapazität (Cov), die an dem Ende angeordnet ist, das nicht mit der Modulationsspule (Ls) des Zweigs des Schaltzweigs (13) verbunden ist, der die beiden Dioden (D) und Masse enthält,
Filtermittel (7) parallel zur Kapazität (Cov), wobei das Filtermittel umfasst:

eine Gruppe, die aus einer Diode (9) in Reihe mit einer Filterspule (Lf) besteht, wobei diese Gruppe in das Zweigende des Schaltzweigs (13) geschaltet ist, der die beiden Dioden (D) und einen Verbindungspunkt (J) bei enthält das Ende der Filterspule (Lf),
eine zwischen diesem Verbindungspunkt (J) und Masse angeschlossene Filterkapazität (Cf),
ein elektrisches Energierückgewinnungsmodul (8), das eingangsseitig zwischen den Verbindungspunkt (J) der Filtermittel (7) und Masse geschaltet ist und das am Ausgang eine zwischen die Eingangsphase geschaltete Kapazität (Crec) aufweist und die Masse,
bei dem die Leistungsmodule, die Modulationsschaltung und das Energierückgewinnungsmodul auf einer Leiterplatte so verbunden sind, dass zumindest die Leistungsmodule und die Modulationsspule (Ls) mit einer Luftkühlung (22) in Kontakt stehen, wobei das Umwandlungssystem Filtermittel umfasst, die mindestens eine Diode (9) in Reihe mit einer Filterspule (Lf) und einem Filterkondensator (Cf) pro Ausgangsphase der Systemumwandlungseinheit umfassen, wobei jede Gruppe aus der Diode (9) und dem besteht Filterspule (Lf), die an einem Filtermodul (10) montiert ist, das an dem Luftkühlungskühler befestigt ist.

2. System nach Anspruch 1, wobei der Luftkühlungsradiator eine im Wesentlichen ebene Metallplatte (20) und mindestens eine Rippe (21) auf der Seite der Metallplatte (20) gegenüber der Seite umfasst, die mit dem Schalter in Kontakt steht Arme (A, B, C) und die Modulationsspule (Ls), wobei die Metallplatte (20) im Wesentlichen parallel zu der gedruckten Leiterplatte angeordnet ist.

3. System nach Anspruch 2, wobei der Luftkühlstrahler (22) eine Vielzahl von Rippen (21) aufweist, die im Wesentlichen senkrecht zu der Metallplatte (20) und parallel zueinander verlaufen.

4. System nach einem der vorhergehenden Ansprüche, wobei das Modul zur Rückgewinnung elektrischer Energie drei Zweige umfasst, die in einem Verbindungspunkt (P) verbunden sind, mit:

- einen ersten Zweig mit einem Schalter (6),
- einen zweiten Zweig mit einer Diode (4),
- ein dritter Zweig mit einer Induktivität (Lrec), und
- ein Kondensator (3).

5. System nach einem der vorhergehenden Ansprüche, wobei das Umwandlungssystem eine Steuerplatine und/oder eine Stromversorgungsplatine umfasst, die mit der Leiterplatte auf der dem Kühler (22) gegenüberliegenden Seite verbunden ist.

6. Verfahren zum Zusammenbauen eines Konversionssystems nach einem der vorhergehenden Ansprüche, **dadurch gekennzeichnet, dass** folgende Schritte durchgeführt werden:

a) Montieren der Schaltarme (A, B, C) auf der Leiterplatte;
b) Montieren mindestens einer Modulationsspule (Ls) an dem Luftkühlungsradiator (22);
c) Positionieren der Leiterplatte, um die Schaltarme (A, B, C) in Kontakt mit dem Luftkühlungsradiator (22) zu bringen; und
d) Montieren des Modulationskondensators (Cs) und des Moduls zur Rückgewinnung elektrischer Energie auf der Leiterplatte, wobei mindestens ein Filtermodul (10) durch die Reihenschaltung einer Diode (9) und der Spule (Lf) gebildet wird, und vor dem Montieren der Schaltarme (A, B, C) auf der Leiterplatte, Montieren der Filtermodule (10) auf dem Luftkühlungsradiator (22).

7. Verfahren nach Anspruch 6, wobei jeder Schaltarm mindestens ein Leistungsmodul (13) umfasst, wobei jedes Leistungsmodul auf der Leiterplatte montiert wird.

8. Verfahren nach einem der Ansprüche 6 oder 7, wobei die Baugruppen auf der gedruckten Schaltung durch Schweißen, Schrauben und/oder Schnappbefestigung hergestellt werden.

9. Verfahren nach einem der Ansprüche 6 bis 8, wobei das Verfahren einen Montageschritt einer Steuerplatine und/oder einer Stromversorgungsplatine an der gedruckten Schaltung auf der dem Luftkühler gegenüberliegenden Seite umfasst.

10. Motorsystem mit mindestens einem elektrischen Energiespeicher und einer dreiphasigen elektrischen Maschine (M), **dadurch gekennzeichnet, dass** das Motorsystem ein Umwandlungssystem nach einem der Ansprüche 1 bis 5 umfasst, um elektrische Energie der elektrischen Energie umzuwandeln Speichermittel in dreiphasiger elektrischer Wechselenergie für die dreiphasige elektrische Maschine (M).

**Claims**

1. System for the conversion of DC electric power into three-phase AC electric power comprising three switching arms (A, B, C), a circuit for modulating voltage and intensity variations, and an electric power recovery module, said modulating circuit comprising a modulation capacitor (Cs) and a modulation coil (Ls) per output phase of said conversion system, each switching arm (A, B, C) comprising at least one power module in the form of a block, said power module comprising two inputs (E1, E2) adapted to be connected to continuous inputs of said conversion system, two switches (1) placed in series inside said inputs (E1, E2), and a first output (S) arranged inside said two switches (1), said first output (S) being adapted to be connected to an alternative output phase of said conversion system,
wherein the conversion system includes:

a continuous input phase powered by a voltage (Udc) in relation to a ground, a modulation coil (Ls) wherein a first end of the modulation coil (Ls) is connected to the continuous input phase,
the switching arm (13) is connected to a second end of the modulation coil (Ls), the switching arm (13) comprises:
two switches (1) in series on a branch which is connected on one side to the second end of the modulation coil (Ls) and on the other side to ground, two diodes (D) in series on a branch which is connected at the junction between the second end of the modulation coil (Ls) and the branch comprising the two switches (1), an alternative current output (S) which is located in the midpoint between the two switches (1),
a modulation capacitance (Cs), of which one end is connected at the junction point between the two diodes (D) of the switching arm (13) and of which the other end is connected to the output (S) of the switching arm (13),
a capacitance (Cov) which is arranged in the end not connected to the modulation coil (Ls) of the branch of the switching arm (13) which includes the two diodes (D) and the ground,
filtering means (7), in parallel with the capacity (Cov), the filtering means comprising:

a group formed by a diode (9) in series with a filter coil (Lf), this group being connected in the branch end of the switching arm (13) which includes the two diodes (D) and a junction point (J) at the end of the filter coil (Lf),
a filtering capacity (Cf) connected between this junction point (J) and the ground,
an electrical energy recovery module (8), which is connected at the input between the junction point (J) of the filtering means (7) and the ground and which has at the output a capacitance (Crec) connected between the DC input phase and the mass,
in which the power modules, said modulation circuit and said energy recovery module are connected on a printed circuit board in such a way that at least said power modules and said modulation coil (Ls) are in contact with an air cooling radiator (22), wherein said conversion system comprises filtering means comprising at least one diode (9) in series with a filtering coil (Lf) and a filtering capacitor (Cf) for each output phase of said system conversion unit, each group formed by said diode (9) and said filter coil (Lf) being mounted on a filter module (10) fixed on said air cooling radiator.

2. System according to claim 1, wherein said air cooling radiator comprises a substantially planar metal plate (20), and at least one fin (21) on the side of said metal plate (20) opposite to the side in contact with said switching arms (A, B, C) and said modulation coil (Ls), said metal plate (20) being arranged substantially parallel to said printed circuit board.

3. System according to claim 2, wherein said air cooling radiator (22) has a plurality of fins (21) substantially perpendicular to said metal plate (20) and parallel to each other.

4. System according to one of the preceding claims, in which said electrical power recovery module comprises three branches connected in a junction point (P), with:

- a first branch comprising a switch (6),
- a second branch comprising a diode (4),
- a third branch comprising an inductance (Lrec), and
- a capacitor (3).

**5.** System according to one of the preceding claims, wherein said conversion system comprises a control board and/or a power supply board connected to said printed circuit board on the side opposite to said cooling radiator (22).

**6.** Method for assembling a conversion system according to one of the preceding claims, **characterized in that** the following steps are carried out:

a) assembling said switching arms (A, B, C) on said printed circuit board;
b) assembling at least one modulation coil (Ls) on said air cooling radiator (22);
c) positioning said printed circuit board so as to bring the switching arms (A, B, C) in contact with said air cooling radiator (22); and
d) assembling said modulation capacitor (Cs) and said electric power recovery module on said printed circuit board, in which at least one filtering module (10) is formed by the association in series of a diode (9) and said coil (Lf), and, before assembling said switching arms (A, B, C) on said printed circuit board, assembling said filter modules (10) on said air cooling radiator (22).

**7.** Method according to claim 6, wherein each switching arm comprises at least one power module (13), each power module is assembled on said printed circuit board.

**8.** Process according to one of claims 6 or 7, wherein said assemblies on said printed circuit are made by welding, screwing and/or snap fastening.

**9.** Process according to one of claims 6 to 8, wherein said process comprises an assembly step of a control board and/or a power supply board to said printed circuit on the side opposite to said air cooling radiator.

**10.** Motor system comprising at least one electric power storage means and a three-phase electric machine (M), **characterized in that** the motor system comprises a conversion system according to one of claims 1 to 5, for converting electric energy of said electrical energy storage means into three-phase alternating electric energy for said three-phase electric machine (M).

ART ANTERIEUR
Figure 1

Figure 2

**ART ANTERIEUR**
**Figure 3**

**Figure 4**

**Figure 5a**

**Figure 5b**

Figure 6

Figure 7

Figure 8

18

13

19

14

17

15

16

Figure 9

22

20

21

Figure 10

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 11016854 A
- DE 10020137
- US 4566051 A
- US 5184291 A
- US 2005270745 A